Europäisches Patentamt

European Patent Office

Office européen des brevets

(11) Publication number: **0 192 981**
**B1**

# EUROPEAN PATENT SPECIFICATION

(45) Date of publication of patent specification: **27.12.89**

(51) Int. Cl.⁴: **G 01 R 31/28**

(21) Application number: **86101126.0**

(22) Date of filing: **29.01.86**

(54) Circuit for measuring characteristics of a device under test.

(30) Priority: **31.01.85 JP 17099/85**
**31.01.85 JP 17100/85**

(43) Date of publication of application:
**03.09.86 Bulletin 86/36**

(45) Publication of the grant of the patent:
**27.12.89 Bulletin 89/52**

(84) Designated Contracting States:
**DE FR GB NL**

(56) References cited:
**US-A-3 928 813**

(73) Proprietor: **Hewlett-Packard Company**
**Mail Stop 20 B-O 3000 Hanover Street**
**Palo Alto California 94304 (US)**

(72) Inventor: **Toshio, Tamamura**
**1540-332, Kawaguchi-cho**
**Hachioji-shi Tokyo 193 (JP)**

(74) Representative: **Schulte, Knud, Dipl.-Ing.**
**c/o Hewlett-Packard GmbH Europ. Patent- und**
**Lizenzabteilung Postfach 1430 Herrenberger**
**Strasse 130**
**D-7030 Böblingen (DE)**

Courier Press, Leamington Spa, England.

**Description**

The present invention is concerned with the measurement of characteristics of a device under test (DUT).

Generally the impedance, gain, phase or quality of a DUT, for example a resistor, a capacitor, an amplifier, a digital-to-analog converter etc. can be measured by providing an a.c. signal to the DUT and then comparing the input and output a.c. signals of the DUT or analyzing the output a.c. signal of the DUT. For measurements at high frequency it may be required that the high frequency output signal of the DUT be converted to an intermediate frequency signal at lower frequency, using a selected local frequency signal. When it is required that the high frequency output signal of the DUT be sampled and measured at high accuracy, the local frequency signal should have high resolution in frequency and be pure. In the prior art, however, it was difficult to measure the characteristics of the DUT accurately because the required accuracy and resolution make the known measurement circuits, especially the circuitry for generating the desired local frequency signal, remarkably complicated.

The object of the present invention is to provide a circuit for measuring characteristics of a DUT with high accuracy while allowing for comparatively simple circuit construction.

In accordance with claim 1, this objective is met by providing an apparatus for measuring characteristics of the DUT comprising first generating means for generating the input signal as a periodic signal having a period T, second generating means for generating a sampling signal as a periodic signal having a period $t = nT + T/m$, where n and m are integers, first sampling means for receiving the output signal from the DUT and the sampling signal, second sampling means for receiving the input signal to the DUT and the sampling signal, first converting means for converting the output signal of the first sampling means to first digital values, second converting means for converting the output signal of the second sampling means to second digital values, and calculating means coupled to the first and to the second converting means for calculating characteristics of the DUT from the first and the second digital values.

From US patent US—A—3,928,813 it is known in connection with a frequency synthesizer to generate signals having frequencies f which are rational multiples of a reference frequency $f_{ref}$, i.e.:

$$f = (N + k/M)f_{ref},$$

whereby N, k, and M are integers.

Both signal sources in an apparatus according to the invention may be coupled to one single crystal oscillator for both, and in accordance with claim 2 one or both may be constructed as a fractional N oscillator such as is known from US patent US—A—3,928,813.

The embodiment in accordance with claim 3 further improves measurement accuracy by reducing errors arising from jitter, phase noise etc. In the embodiment of claim 3, the a.c. signal of a crystal oscillator (the first signal source) is applied directly to the DUT, and the second signal source is coupled to the crystal oscillator and includes a phase locked loop which provides for higher accuracy of the sampling signal.

In all embodiments the signals are sampled and converted to digital values by A/D converters and input to a microprocessor. The input signals and the output signals of the DUT are analyzed by the microprocessor to calculate the characteristics of the DUT.

The invention will now be described in detail with reference to the accompanying drawings.

Figure 1 is a block diagram of a circuit for measuring phase and amplitude of a.c. signals passed through a DUT.

Figure 2 shows another circuit for the same purpose including a phase locked loop.

Figure 3 explains the sampling operation for sampling a.c. signals in any one of the circuits shown in Figures 1 and 2.

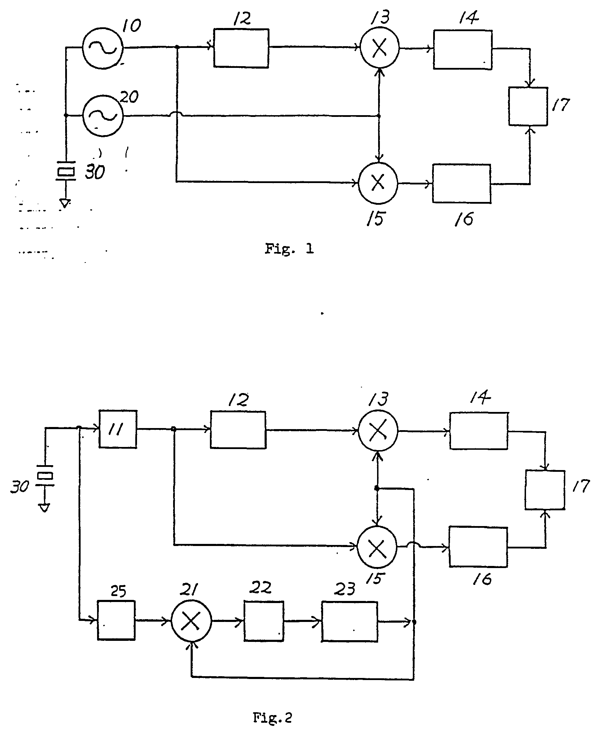

Figure 1 shows a circuit for measuring RF signals applied to and transmitted by a device under test (DUT). The circuit operates to perform a measurement as follows. Units 10 and 20 are first and second signal sources of the circuit, and both signal sources may include fractional N oscillators which are coupled to an output signal of a crystal oscillator 30 and which can provide highly accurate a.c. signals for use in the circuit. Element 12 is a DUT, elements 13 and 15 are sampler circuits for sampling input and output a.c. signals at the DUT. In the present circuit, sampler 13 under control by the output signal of the second signal source 20 samples and holds the momentary amplitude of the output signal passed through the DUT. Sampler 15 under control by the output signal of the second signal source 20 samples and holds the momentary amplitude of the output signal of the first signal source 10, which is applied to DUT 12. The desired information, for example impedance, resistance, capacitance etc. can be obtained by calculations from the momentary amplitude values of these two signals with a microprocessor 17, to which end the momentary amplitude values are respectively converted to digital values with A/D converter 14 and 16.

It may, however, in certain applications such as a measurement of the input to output transfer characteristics of circuits such as an amplifier or a digital-to-analog converter not be necessary to utilize the output signals of A/D converter 16 as will be apparent to persons that are knowledgeable in the art.

The sampling signal generated by signal source 20 serves to define sampling points in time in accordance with the following equation (1) wherein the output period of the first signal is T seconds and the period of the sampling signal is t seconds.

$$t = nT + T/m \qquad (1)$$

In equation (1) m and n are positive integers and m is the number of samplings during the period T. Accordingly, the amplitude values Ap for the pth harmonic of the first signal can be calculated by application of a Digital Fourier Transformation (DFT), if a number m of data points of the first signal are measured during period T. The discrete Fourier Transform may be expressed as follows:

$$A_p = \frac{1}{N} \sqrt{\left\{\sum_{k=1}^{m} (\sin p \cdot \frac{2\pi k}{m}) \cdot \text{Data } m\right\}^2 + \left\{\sum_{k=1}^{m} (\cos p \cdot \frac{2\pi k}{m}) \cdot \text{Data } m\right\}^2} \qquad (2)$$

Furthermore the amplitude values of higher order harmonics may be calculated by expanding the Fourier series. By such an amplitude measurement the characteristics of an amplifier or a DAC can be measured. It is also readily seen that if a two channel sampler is used, the phase, gain or impedance information available between these channels can be analyzed.

If, for example, the frequency of the first signal is 100 MHz, its period T is 10 ns. By substitution into equation (1), setting n to the value of 100 and setting m to the value of 128, the period of the sampling signal t may be calculated as follows:

$$t = 10 \times 100 + 10/128 \text{ ns.}$$

This means that one sampling is done for each 100 periods of the signal to be sampled, with each sampling point being relatively offset from the preceding sampling point (in relation to the signal to be sampled) by 1/128 of the period of the signal to be sampled, i.e. by T/128. In other words, one sampling occurs within each 100th period of the signal to be sampled, and the sampling points are offset from the start of the period of that signal in increments of T/128. The resulting frequency of the sampling signal is 999.92188... kHz. Therefore it is required that the sampling signal be generated by an oscillator having high resolution and accuracy.

It is known that fractional N oscillators can settle on any rational frequency value with a resolution of $1/10^{16}$ and thus generate highly accurate sampling signals easily.

Figure 2 shows a modification of the circuit shown in Figure 1. Elements shown in Figure 2 have the same designation as in Figure 1 if their function is equivalent. If, as in Figure 1, the output signal of a first fractional N oscillator is applied directly to the DUT and the output of a second fractional N oscillator is used as a sampling signal, slight measurement errors may occur from jitter and phase noise caused by the fractional N oscillators. In Figure 2 the a.c. signal of a crystal oscillator 30 is applied to the DUT 12 via a filter 11. Output and input signals of the DUT 12 are respectively applied to an input terminal of a sampler 13 and a sampler 15. The second input terminals of samplers 13 and 15 receive sampling signals defined in accordance with equation (1) above which are generated as follows.

The output signal of crystal oscillator 30 is applied to a fractional N oscillator 25, and also applied to one input terminal of a phase detector 21. The phase detector is included in a phase locked loop (PLL) further including a filter 22 and a voltage-controlled crystal oscillator 23 as shown in Figure 2. The purpose of the phase locked loop is to set the frequency of the sampling signal to the value of the fractional N oscillator 25. Thus a highly accurate sampling signal may be generated at any desired frequency 1/t without relatively large noise to cause measurement error, and may be applied to the samplers 13 and 15, by locking its frequency to the frequency of fractional N oscillator 25.

The a.c. signal applied to DUT 12 is generated directly by crystal oscillator 30 which further improves the accuracy of measurement. The output signal of crystal oscillator 30 may be applied to DUT 12 via a frequency divider.

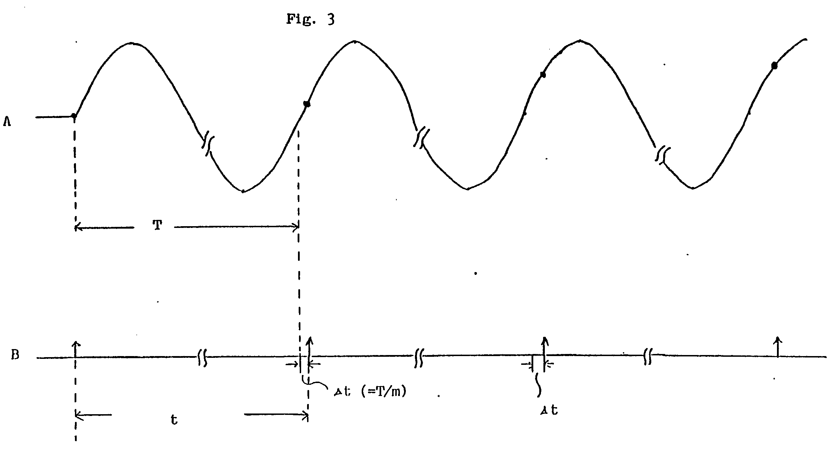

Figure 3 is a timing chart which explains the sampling operation taking place in the measurement circuit shown in Figures 1 and 2. Curve A is representative of an input signal to DUT 12, and curve B represents sampling signals. The momentary amplitude of the a.c. signal having a period of T is obtained at each of the successive sampling points falling on times t = nT + T/m as shown in Figure 3. Thus, by dividing the period T into m offset increments T/m sampling is performed at m different points within the period of the signal A. The data is converted by A/D converters 14, 16 and subsequently phase and amplitude of the input and output a.c. signals may be calculated by microprocessor 17 in accordance with the DFT algorithm.

For instance, the output frequency of crystal oscillator 30 may be 100 MHz (T = 10 ns) and the sampling frequency may be some value around 1 MHz. In particular the sampling frequency to be selected by the fractional N oscillator 25 is defined to divide the period of the 100 MHz frequency into m offset increments T/m for determination of the sampling times. If n is 100 and m is 10, the sampling frequency generated by fractional N oscillator 25 and voltage-controlled crystal oscillator 23 is 1/1.001 MHz which may be generated as a frequency of 999.0009990009990 kHz with a resolution of $1/10^{16}$. In this case the pull-in range of oscillator 23, or frequency deviation from the central frequency of oscillator 23 of 1 MHz, is about 1 kHz. Further, if n is the same and m is set to 1000, the sampling frequency would be 999.9900000999990 kHz. In this case the pull-in range of oscillator 23, or in other words the frequency deviation from the central frequency of oscillator 23 of 1 MHz, is narrowed to 0.01 kHz. Accordingly, if a larger number of samplings m is selected, the number of samples taken to represent one signal cycle increases and the pull-in range, or deviation from center frequency, of voltage-controlled crystal oscillator 23 becomes narrower. The narrower the pull-in range becomes, however, the better the quality of the output signal of oscillator 23 will be because the jitter will be reduced. Therefore the measurement of a.c. signals with higher accuracy can obviously be expected.

## Claims

1. An apparatus for measuring characteristics of a device under test (DUT), comprising
— first generating means (10, 30) for generating an HF-input signal for the DUT as a periodic signal having a period T;
— second generating means (20, 30) for generating a sampling signal as a periodic signal having a period $t = nT + T/m$, where n and m are integers;
— first sampling means (13) for receiving an output signal from the DUT (12) and the sampling signal coming from the second generating means (20);
— second sampling means (15) for receiving the input signal to the DUT (12) and the sampling signal coming from the second generating means (20);
— first converting means (14) for converting the output signal of the first sampling means (13) to first digital values;
— second converting means (16) for converting the output signal of the second sampling means (15) to second digital values; and
— calculating means (17) coupled to the first (14) and to the second (16) converting means for calculating characteristics of the DUT (12) from the first and the second digital values.

2. An apparatus as in claim 1 wherein the second generating means includes a fractional N oscillator (20, 25).

3. An apparatus as in claim 1 or 2 wherein the first generating means is a crystal oscillator (30); and the second generating means includes a fractional N oscillator (25) and a phase locked loop circuit (21, 22, 23) coupled to the fractional N oscillator (25) for generating the sampling signal as an output of the phase locked loop circuit.

## Patentansprüche

1. Vorrichtung zum Messen der Kenngrößen eines zu prüfenden Geräts (DUT), mit
— ersten Mitteln (10, 30) zur Erzeugung eines Hochfrequenz-Eingangssignals für das DUT als periodisches Signal mit der Periode T;
— zweiten Mitteln (20, 30) zur Erzeugung eines Abtast-Signals als periodisches Signal mit der Periode $t = nT + T/m$, wobei n und m ganze Zahlen sind;
— einer ersten Abtast-Einrichtung (13) zum Empfang eines vom DUT (12) kommenden Ausgangs-Signals und des von den zweiten Mitteln (20) kommenden Abtast-Signals;
— einer zweiten Abtast-Einrichtung (15) zum Empfang des dem DUT (12) zugeführten Eingangs-Signals und des von den zweiten Mitteln (20) kommenden Abtast-Signals;
— einer ersten Umwandlungs-Einrichtung (14) zur Umwandlung des Ausgangs-Signals der ersten Abtast-Einrichtung (13) in erste Digitalwerte;
— einer zweiten Umwandlungs-Einrichtung (16) zur Umwandlung des Ausgangs-Signals der zweiten Abtast-Einrichtung (15) in zweite Digitalwerte, und
— einer mit der ersten (14) und zweiten (16) Umwandlungs-Einrichtung gekoppelten Recheneinrichtung (17) zur Berechnung der Kenngrößen des DUT (12) aus den ersten und zweiten Digitalwerten.

2. Vorrichtung nach Anspruch 1, dadurch gekennzeichnet daß die ersten Signal-Erzeugungsmittel einen Bruchteil-Oszillator (20, 25) umfassen.

3. Vorrichtung nach Anspruch 1 oder 2, dadurch gekennzeichnet, daß die ersten Signal-Erzeugungsmittel aus einem Quarz-Oszillator (30) bestehen und daß die zweiten Signal-Erzeügungsmittel einen Bruchteil-Osczillator (25) und einen mit dem Bruchteil-Oszillator (25) gekoppelten Phasenregelkreis (21, 22, 23) zur Erzeugung des Abtast-Signals als Ausgangs-Signal des Phasenregelkreises umfassen.

## Revendications

1. Un appareil de mesure des caractéristiques d'un composant à tester, comprenant:
— des premiers moyens générateurs (10, 30), produisant un signal d'entrée haute fréquence destiné au composant à tester, sous forme d'un signal périodique de période T,
— des seconds moyens générateurs (20, 30), produisant un signal d'échantillonnage sous forme d'un signal périoidique de période $t = nT + T/m$, n et m étant des entiers,

— des premiers moyens d'échantillonnage (13), recevant un signal de sortie du composant à tester (12) et le signal d'échanillonnage provenant des seconds moyens générateurs (20),

— des seconds moyens d'échantillonnage (15), recevant le signal d'entrée appliqué au composant à tester (12) et le signal d'échantillonnage provenant des seconds moyens générateurs (20),

— des premiers moyens convertisseurs (14), convertissant le signal d'entrée des premiers moyens d'échantillonnage (13) en premières valeurs numériques,

— des seconds moyens convertisseurs (16), convertissant le signal de sortie des seconds moyens d'échantillonnage (13) en secondes valeurs numériques, et

— des moyens de calcul (17), reliés aux premiers (14) et aux seconds (16) moyens convertisseurs, calculant les caractéristiques du composant à tester (12) d'après les premières et secondes valeurs numériques.

2. L'appareil de la revendication 1, dans lequel les seconds moyens générateurs comprennent un oscillateur à rang fractionnaire (20, 25).

3. L'appareil de la revendication 1 ou 2, dans lequel les premiers moyens générateurs sont constitués d'un oscillateur à quartz (30), et les seconds moyens générateurs comprennent un oscillateur à rang fractionnaire (25) et un circuit en boucle à verrouillage de phase (21, 22, 23) relié à l'oscillateur à rang fractionnaire (25) de manière à produire le signal d'échantillonnage sous forme d'un signal de sortie du circuit en boucle à verrouillage de phase.

Fig. 1

Fig.2

1

Fig. 3